# EUROPEAN PATENT APPLICATION

(11) **EP 1 522 609 A2**
(43) Date of publication of application: **13.04.2005**
(21) Application number: 04023675.4
(22) Date of filing: 05.10.2004
(51) Int. Cl.: C23C 14/14, C23C 14/34, C23C 18/16, C23C 28/02, C25D 5/02, C25D 5/10

(54) **Conductive sheet having a metal layer on at least one portion of an insulating substrate, product using the same, and manufacturing method thereof**

(30) Priority: 06.10.2003 JP 2003346921
(71) Applicant: FCM Co., Ltd., Osaka-shi, Osaka (JP)
(72) Inventor: Miura, Shigeki, Osaka-shi Osaka (JP)
(74) Representative: Grünecker, Kinkeldey, Stockmair & Schwanhäusser Anwaltssozietät

(57) **Abstract**

The present invention relates to a conductive sheet (1) having a metal layer (3) formed on at least a portion of a surface of an insulating substrate (2), wherein the insulating substrate (2) has a long size of 1-10000 m in length, at least a portion of the surface thereof is irradiated with cations to set a surface roughness value Ra of an irradiated portion to 0.2-200 nm, and the metal layer (3) is formed on the portion irradiated with cations by a sputtering method or a deposition method.

## Description

This nonprovisional application is based on Japanese Patent Application No. 2003-346921 filed with the Japan Patent Office on October 6, 2003, the entire contents of which are hereby incorporated by reference.

### BACKGROUND OF THE INVENTION

### Field of the Invention

The present invention relates to a conductive sheet. More specifically, the present invention relates to a conductive sheet useful for a semiconductor product, an electrical product, an electronic product, a circuit board, an antenna circuit board, a package, an electromagnetic wave shielding material, an automobile, a solar cell, an IC card, and the like.

### Description of the Background Art

A conductive sheet having an insulating substrate on which a metal layer or a conductive layer is formed is conventionally known. Japanese Patent Laying-Open No. 2001-200376, for example, proposes a conductive sheet used as an electromagnetic wave shielding material including a first metal layer formed on a non-conductive support medium, which is an insulating substrate as described above, by physical vapor deposition and a second metal layer formed thereon by electroplating.

Adhesion between the insulating substrate and the metal layer of the conductive sheet having such construction, however, is sometimes insufficient, and various attempts have been made to enhance the adhesion. An example of such attempts is to perform chemical processing with chemicals or physical processing such as blast processing for the insulating substrate prior to formation of the metal layer.

Sufficient adhesion, however, is still not obtained with those attempts. Besides, problems caused by such attempts, such as extension of the insulating substrate itself or an excessively uneven surface thereof, have been pointed out. In particular, when the insulating substrate itself is extended or made excessively uneven, a fine circuit cannot be formed in a subsequent step to form a circuit with the metal layer or the conductive layer.

On the other hand, Japanese Patent Laying-Open No. 2001-277424 discloses a metalized polyimide film including a metal layer formed on a surface of a polyimide film. The surface of the polyimide film of the metalized polyimide film is subjected to a roughening process to enhance adhesion between the polyimide film and the metal layer. The roughening process is performed by alkaline etching, plasma processing or corona processing, and thus sufficient adhesion is still not obtained with the roughening process.

In addition, Japanese Patent Laying-Open No. 11-310876 describes a covered member formed by performing an unevenness providing process for a surface of a base material and covering the surface of the base material with a cover film. Though various techniques to enhance adhesion between the base material and the cover film are described therein, information to enhance adhesion between the insulating substrate and the metal layer is not provided because the base material is a steel material or the like and is different from a material of the insulating substrate.

Japanese Patent Laying-Open No. 62-143846 describes a method of forming an antireflection coating on a transparent substrate. The method, however, only discloses that an uneven surface formed on the transparent substrate is similarly formed on a surface of the antireflection coating, and thus information to enhance adhesion between the insulating substrate and the metal layer is not provided.

### SUMMARY OF THE INVENTION

The present invention is made in view of the current state as described above. An object of the present invention is to provide a conductive sheet having high adhesion between an insulating substrate and a metal layer and enabling formation of a fine circuit, a product using the conductive sheet, and a manufacturing method of the conductive sheet.

The present invention relates to a conductive sheet having a metal layer formed on at least a portion of a surface of an insulating substrate, wherein the insulating substrate has a long size of 1-10000 m in length, at least a portion of the surface thereof is irradiated with cations to set a surface roughness value Ra of an irradiated portion to 0.2-200 nm, and the metal layer is formed on the portion irradiated with cations by a sputtering method or a deposition method.

In the conductive sheet according to the present invention, a conductive layer can be formed on at least a portion of a surface of the metal layer by an electroplating or electroless plating method. In addition, the metal layer and the conductive layer can form a circuit.

In the conductive sheet according to the present invention, circuits of a plurality of units can be formed with the metal layer and the conductive layer on the insulating substrate, and the insulating substrate can be cut to divide the circuits of the plurality of units, unit by unit.

Furthermore, a product according to the present invention can use the conductive sheet described above, and can be any of a semiconductor product, an electrical product, an electronic product, a circuit board, an antenna circuit board, a package, an electromagnetic wave shielding material, an automobile, a solar cell, and an IC card.

The present invention further relates to a manufacturing method of a conductive sheet having a metal layer formed on at least a portion of a surface of an insulating substrate, including the steps of: using the insulating substrate having a long size of 1-10000 m in length and continuously irradiating at least a portion of the surface thereof with cations to set a surface roughness value Ra of an irradiated portion to 0.2-200 nm; and forming the metal layer on the portion irradiated with cations by a sputtering method or a deposition method.

In addition, in the manufacturing method of a conductive sheet according to the present invention, the step of irradiating with cations and the step of forming the metal layer can be successively performed within one apparatus.

The manufacturing method of a conductive sheet according to the present invention can further include the step of forming a conductive layer on at least a portion of a surface of the metal layer by an electroplating or electroless plating method.

In addition, the manufacturing method of a conductive sheet according to the present invention can further include the step of forming a circuit for the metal layer and the conductive layer.

Furthermore, the manufacturing method of a conductive sheet according to the present invention can further include the steps of forming circuits of a plurality of units with the metal layer and the conductive layer on the insulating substrate, and cutting the insulating substrate to divide the circuits of the plurality of units, unit by unit.

In the conductive sheet of the present invention having a construction as described above, particularly because the insulating substrate having a long size is used, a portion or a whole of a surface thereof is irradiated with cations to attain suitable surface roughness, and the metal layer is formed on the irradiated portion, the insulating substrate and the metal layer are stacked with substantially high adhesion and formation of a fine circuit is enabled.

In addition, a useful product having a fine circuit, such as a semiconductor product, an electrical product, an electronic product, a circuit board, an antenna circuit board, a package, an electromagnetic wave shielding material, an automobile, a solar cell, or an IC card, can be obtained using the conductive sheet according to the present invention.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a schematic cross-sectional view of a conductive sheet according to the present invention.
Fig. 2 is a schematic cross-sectional view of the conductive sheet according to the present invention in which a conductive layer is formed.
Fig. 3 is a schematic cross-sectional view of the conductive sheet according to the present invention in which a circuit is formed.

### DESCRIPTION OF THE PREFERRED EMBODIMENTS

Details of a conductive sheet according to the present invention will be described below. The following descriptions are given referring to the drawings, and the same reference characters in the drawings of the present application indicate the same or corresponding portions.

### <Conductive Sheet>

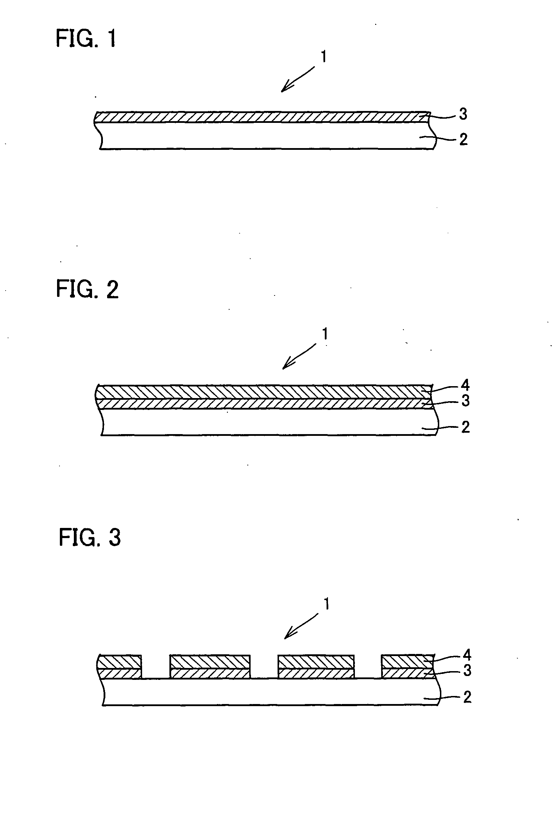

As shown in Fig. 1, a conductive sheet 1 of the present invention has a metal layer 3 formed on at least a portion of a surface of an insulating substrate 2. In addition, as shown in Fig. 2, a conductive layer 4 can be formed on at least a portion of a surface of metal layer 3 of conductive sheet 1 of the present invention, and metal layer 3 and conductive layer 4 can form a circuit, as shown in Fig. 3.

### <Insulating substrate>

As insulating substrate 2 used as a base material of conductive sheet 1 of the present invention, a substrate of any conventionally known material which can be used for this purpose may be used without specific limitation provided that it has a long size. In particular, a substrate in a form of a thin film is suitable because it is suitable for formation of the metal layer described below and the like, and is suitably processed as a long continuous object such as a roll, which can enhance a production efficiency.

Examples of such insulating substrate include films made of polyester such as PET or PEN, polyimide, aramid, polysulfone, polyetherimide, polyphenyleneoxide, a liquid crystal polymer, a glass fiber reinforced epoxy resin, a phenolic resin, an acrylic resin, and the like. In particular, it is preferable to use the film made of polyester such as PET or PEN, polyimide, or a glass fiber reinforced epoxy resin, which has good flexibility and allows higher performance.

Suitable thickness of the insulating substrate is 1-300 µm, preferably about 12-60 µm. When the thickness is less than 1 µm, strength is decreased and the insulating substrate may not bear the process of irradiation with cations described below. When the thickness is more than 300 µm, rolling of the insulating substrate may be difficult because it has a long size. Even when the rolling is possible, a large processing apparatus will be required because of an excessively large diameter of a roll, resulting in an increased processing cost.

In addition, the insulating substrate preferably has a width of 2-1600 mm, more preferably about 200-1200 mm. When the width is less than 2 mm, reeling of the insulating substrate for use as a roll becomes difficult, and when the width is more than 1600 mm, a large processing apparatus will be required, which increases a cost of equipment.

As described above, the insulating substrate has a long size. The length is preferably 1-10000 m, more preferably about 100-3000 m. When the length is less than 1 m, the use of the insulating substrate as a roll is difficult and processing efficiency decreases. When the length is more than 10000 m, as a target is exhausted during formation of the metal layer described below, replacement of the target is needed, which makes continuous processing difficult.

It is to be noted that, "a long size" of the insulating substrate of the present invention indicates the length as described above, which is suitable for use in a rolled form. Insulating substrates shorter than the length described above, however, are also included in the present invention when a plurality of sheets of the insulating substrates are affixed together to a long film for supporting to enable handling as a long substrate, adopting a method similar to carrier tape processing described below. A long substrate formed by affixing such sheets of insulating substrates to each other is also included in the present invention.

As described above, the insulating substrate used in the present invention is characterized in that it has a long size because, as described below, it is suitable for irradiation with cations.

Insulating substrates subjected to various processings or having various constructions can be used in the present invention. Examples of the processings include hole processing for opening a hole such as a via hole, a through hole, or an alignment hole, mask processing and carrier tape processing (processing for temporarily affixing a reinforcement film to one surface of the insulating substrate in order to increase strength when the insulating substrate is thin). The constructions include a construction in which metal foil is affixed to one surface of the insulating substrate.

### <Irradiation with Cations>

At least a portion of a surface of insulating substrate 2 used in the present invention is irradiated with cations to set a surface roughness value Ra of an irradiated portion to 0.2-200 nm. By setting the surface roughness value Ra to 0.2-200 nm, preferably 20-80 nm, adhesion between the insulating substrate and the metal layer described below is enhanced dramatically and the conventional problems are solved.

The surface roughness value Ra less than 0.2 nm is not preferable because sufficient adhesion between the insulating substrate and the metal layer described below is not obtained. On the other hand, the adhesion is not effectively enhanced when the surface roughness value Ra becomes more than 200 nm, but a degree of unevenness of the surface becomes excessively large and formation of a fine circuit becomes difficult.

Herein, the surface roughness value Ra is a kind of a value indicating surface roughness, which is called a center line average. The value is obtained using a probe of, for example, an atomic force microscope (such as a scanning probe microscope SPM-9500J3 manufactured by Shimadzu Corporation) and by setting a measurement range to 2 µm × 2 µm in a contact mode thereof.

Examples of the cations include inert gas ions such as argon ions, oxygen ions (O₂⁺), nitrogen ions (N₂⁺), and mixed ions thereof. It is especially preferable to use an ion beam gun for irradiating an object with ions as an apparatus for irradiation with such cations. It is to be noted that, anions may also be included during the irradiation with the cations.

Though the surface roughness value Ra of the insulating substrate can be set to 0.2-200 nm by methods other than the irradiation with cations as in the present application, such as chemical processing with chemicals or blast processing, high adhesion between the insulating substrate and the metal layer as in the present application cannot be obtained with those methods. Though the reason that such high adhesion can be obtained only by the irradiation with cations as in the present application is not apparent in detail, it is probably because, as a cation has a larger mass than an electron or the like, molecules forming a surface of the insulating substrate is shot or activated at an atomic level by the irradiation with cations, which may attain a very fine and active uneven state.

When the insulating substrate is irradiated with cations, the insulating substrate is heated, and a degree of this heating increases as an amount of irradiation with cations increases. Since the insulating substrate may be deformed with such heating and the deformation makes formation of a circuit described below difficult, the insulating substrate must be cooled to avoid the deformation due to the heating.

Such cooling is often performed by bringing the insulating substrate in contact with a cooling roll just after the irradiation with cations. The cooling with the cooling roll, however, cannot be performed efficiently when the insulating substrate is in a sheet form. Therefore, when the insulating substrate in a sheet form is used, the irradiation with cations is limited within a range in which the deformation due to the heating does not occur, which results in difficulty in obtaining sufficient surface roughness. Thus, the insulating substrate having a long size must be used to obtain sufficient surface roughness by the irradiation with cations as in the present invention.

With the insulating substrate having a long size used in the present invention, the cooling with the cooling roll can be performed efficiently, which can avoid the deformation due to excess heating of the insulating substrate, and thus the amount of irradiation with cations can be increased, which allows to easily obtain the surface roughness value Ra of 0.2-200 nm as described above.

When the insulating substrate is subjected to various processings as described above, it is preferable to perform the irradiation of the insulating substrate with cations after the processings. In addition, when the metal foil is affixed as described above, though the irradiation with cations can be performed either before or after affixing of the metal foil to the insulating substrate, at least a portion of a surface, to which surface the metal foil is not affixed, must be irradiated with cations.

Preferred conditions of the irradiation with cations when the ion beam gun is used are as follows: in an apparatus including the ion beam gun, for example, in a vacuum of 1 × 10⁻³ - 7 × 10⁻¹ Pa, preferably 5 × 10⁻³ - 5 × 10⁻¹ Pa, with 50-500 cc/minute, preferably 80-250 cc/minute of ion material gas, 0.01-5 kW/dm², preferably 0.1-3 kW/dm² of an ion beam gun electrode current, and an irradiation time of 0.001 seconds to 10 minutes, preferably 0.01 seconds to 1 minute.

Though an apparatus including the ion beam gun separately can be used as the apparatus including the ion beam gun, a more preferable apparatus is a sputtering apparatus or a deposition apparatus for forming the metal layer described below which additionally includes the ion beam gun. With using such apparatus, the irradiation with cations and formation of metal layer for the insulating substrate can be performed successively, and the surface of the insulating substrate after the irradiation with cations can be prevented from being inactivated again. As a result, adhesion between the insulating substrate and the metal layer can further be enhanced, and operation efficiency can also be increased.

### <Metal Layer>

Metal layer 3 of the present invention is formed on at least a portion of the surface of insulating substrate 2 described above. At least a portion of the surface of insulating substrate 2 is irradiated with cations, and the metal layer is formed on the irradiated portion having the surface roughness value Ra of 0.2-200 nm by a sputtering or deposition method.

The metal layer has a function of adding conductivity to the conductive sheet, and can be subjected to various processings to form a circuit. When the conductive layer described below is formed, the metal layer acts as a ground layer of the conductive layer to support the conductive layer to be held on the insulating substrate with high adhesion.

As conditions of formation of the metal layer by the sputtering or deposition method, any conventionally known conditions can be selected as appropriate according to a type of an element used and thickness of the metal layer to be formed.

Conditions of formation by the sputtering method can be, for example, as follows: in a sputtering apparatus, in a vacuum of 1 × 10⁻⁴ - 9 × 10⁻¹ Pa, preferably 1 × 10⁻² - 1 × 10⁻¹ Pa, with 50-500 cc/minute, preferably 80-250 cc/minute of argon gas, and 0.01-5 kW/dm², preferably 0.1-3 kW/dm² of a target current. Conditions of formation by the deposition method can be as follows: in a deposition apparatus, in a vacuum of 1 × 10⁻⁵ - 1 × 10⁻³ Pa, preferably 1 × 10⁻⁴ - 1 × 10⁻³ Pa, with an output of 5-100 kW, preferably 10-30 kW.

By forming the metal layer with the sputtering or deposition method, the element forming the metal layer becomes highly dense and even to the surface of the insulating substrate (including a wall surface of each hole when the hole processing is performed as described above). As a result, together with the above-described irradiation of the insulating substrate with cations, high adhesion between the insulating substrate and the metal layer is attained, which high adhesion is a superior effect which cannot be attained with conventional methods.

The metal layer is preferably formed with at least one metal selected from Cu, Ag, Sn, Ni, Cr, Ti, Al, Bi, and Zn, an alloy including at least one of those metals, or an oxide or a nitride of the metal. More preferably, the metal layer can be formed with Cu or an alloy including Cu.

Suitable thickness of the metal layer is 0.001-1 µm, preferably 0.01-0.3 µm. When the thickness is less than 0.001 µm, sufficient conductivity cannot be added and, when the conductive layer described below is formed, the adhesion of the conductive layer cannot be enhanced sufficiently. When the thickness becomes more than 1 µm, the adhesion of the conductive layer is not effectively enhanced, while it becomes disadvantageous as to a cost.

The metal layer can be formed with one layer (a single layer) or stacked two or more layers (a plurality of layers). When two or more layers are stacked, the layers can have the aforementioned thickness as a whole. In addition, when two or more layers are formed, a stacked construction can be formed with, for example, a lower layer mainly acting as a deterioration preventing layer for preventing the conductive layer described below from being deteriorated by oxidation, and an upper layer acting as a ground layer having conductivity.

As a matter of course, the metal layer can be formed on both of front and back surfaces of the insulating substrate. In this situation, the conditions of thickness and the like as described above are applied to each of the front and back surfaces.

As an apparatus for forming the metal layer by the sputtering or deposition method, it is preferable to use an apparatus which continuously processes and then reels up the insulating substrate and, in particular, which is also provided with the ion beam gun as described above, because manufacturing efficiency can be enhanced and inactivation after each processing can be suppressed.

### <Conductive Layer>

Conductive layer 4 of the present invention is formed on at least a portion of a surface of metal layer 3 by an electroplating or electroless plating method. When the hole processing is performed for insulating substrate 2, it is possible to cover a wall surface of the hole or fill the hole with the conductive layer concurrently with formation of the conductive layer.

The conductive layer mainly forms an interconnection layer and has a function of adding conductivity to the conductive sheet. That is, the conductive layer can be subjected to various processings such as etching together with the metal layer to form a circuit. Therefore, the conductive layer is preferably formed with thickness larger than that of the metal layer in terms of enhancement of electric characteristics such as decrease in an electrical resistance.

As conditions of formation of the conductive layer by the electroplating method, any conventionally known conditions can be selected as appropriate according to a type of an element for forming the conductive layer and thickness of the conductive layer to be formed. The formation can be performed, for example, using a plating solution (which includes an appropriate concentration of metal; when the metal is copper, for example, the solution includes 10-300 g/l, preferably 70-200 g/l of copper sulfate, 40-300 g/l, preferably 80-200 g/l of sulfuric acid, 10-100 ppm, preferably 40-70 ppm of chlorine, and other additives) at a solution temperature of 10-80 °C, preferably 20-40 °C, with a current density of 0.01-20 A/dm², preferably 1-10 A/dm². It is particularly preferred to select any of DC, pulse, PR, and chopper as a waveform of an output side during the electroplating.

Formation of the conductive layer by the electroless plating method can be performed using an electroless plating solution of a normal formula with an appropriate pH control.

By forming the conductive layer by the electroplating or electroless plating method, very high adhesion to the metal layer can be attained and thickness of the conductive layer can be increased.

The conductive layer is preferably formed with at least one metal selected from Cu, Au, Ag, Sn, Ni, Bi, and Zn, or an alloy including at least one of those metals. More preferably, the conductive layer can be formed with Cu or an alloy including Cu. In addition, it is preferable that the conductive layer be formed with the same material as the metal layer. With this, higher adhesion to the metal layer can be attained.

Suitable thickness of the conductive layer is 0.5-50 µm, preferably 5-20 µm. When the thickness is less than 0.5 µm, sufficient conductivity cannot be obtained and the electrical resistance becomes excessively large. When the thickness becomes more than 50 µm, the conductivity is not effectively enhanced, while it becomes disadvantageous as to a cost.

The conductive layer can be formed with one layer (a single layer) or stacked two or more layers (a plurality of layers). When two or more layers are stacked, the layers can have the aforementioned thickness as a whole.

As an apparatus for forming the conductive layer by the electroplating or electroless plating method, it is preferable to use an apparatus which continuously processes and then reels up the insulating substrate, because manufacturing efficiency can be enhanced.

### <Formation of Circuit>

Metal layer 3 and conductive layer 4 of the present invention can be subjected to various processings to form a circuit.

The circuit can be formed by, for example, etching after formation of the metal layer and the conductive layer on the insulating substrate as described above. The circuit can also be formed by applying an appropriate mask on the metal layer, forming the conductive layer only on a portion not having the mask applied thereon, and soft-etching a portion having the mask applied thereon. Furthermore, the circuit can be formed by using the insulating substrate previously subjected to mask processing and forming the metal layer and the conductive layer on a portion not having a mask applied thereon, or by a mechanical masking method for mechanically masking a portion of the insulating substrate on which the circuit is not formed.

It is to be noted that, the circuit of the present invention can form an antenna. The conductive sheet having an antenna formed with the circuit is useful as a conductive sheet for an IC card with an integrated antenna.

In addition, in the present invention, circuits of a plurality of units can be formed with the metal layer and the conductive layer on the insulating substrate, and the insulating substrate can be cut to divide the circuits of the plurality of units, unit by unit. That is, a plurality of circuits can be formed on the insulating substrate, and the plurality of circuits formed as such can be divided into units each including one or more circuits by cutting the insulating substrate.

The unit described above includes one or more circuits which are not connected to each other. Each of the plurality of units may have the same or a different construction.

### <Product>

A product according to the present invention uses the conductive sheet which is divided into units as described above. Examples of such product include a semiconductor product, an electrical product, an electronic product, a circuit board, an antenna circuit board, a package, an electromagnetic wave shielding material, an automobile, a solar cell, and an IC card.

### <Manufacturing Method of Conductive Sheet>

A manufacturing method of a conductive sheet according to the present invention relates to a manufacturing method of a conductive sheet having a metal layer formed on at least a portion of a surface of an insulating substrate, which includes the steps of: using the insulating substrate having a long size and continuously irradiating at least a portion of the surface thereof with cations to set a surface roughness value Ra of an irradiated portion to 0.2-200 nm; and forming the metal layer on the portion irradiated with cations by a sputtering or deposition method. Conditions as described above can be used as conditions of irradiation with cations and the sputtering or deposition method for forming the metal layer. It is preferable to use an ion beam gun for the irradiation with cations.

In the manufacturing method of a conductive sheet according to the present invention, the steps of irradiating with cations and forming the metal layer are preferably performed successively within one apparatus. With this, the surface of the insulating substrate after the irradiation with cations can be prevented from being inactivated again, and adhesion between the insulating substrate and the metal layer can further be enhanced while operation efficiency can also be increased. An example of the apparatus suitable for this method is a sputtering apparatus or a deposition apparatus for forming the metal layer which additionally includes the ion beam gun.

The manufacturing method of a conductive sheet according to the present invention can further include the step of forming a conductive layer on at least a portion of a surface of the metal layer by an electroplating or electroless plating method, and the step of forming a circuit for the metal layer and the conductive layer. Conditions as described above can be used as conditions of the electroplating or electroless plating method for forming the conductive layer and formation of the circuit.

The manufacturing method of a conductive sheet according to the present invention can further include the steps of forming circuits of a plurality of units with the metal layer and the conductive layer on the insulating substrate, and cutting the insulating substrate to divide the circuits of the plurality of units, unit by unit. The circuits of the plurality of units can be formed by forming a plurality of circuits according to the conditions of formation of the circuit described above, and any conventionally known method can be adopted as a method for cutting the insulating substrate.

### [Examples]

The present invention will be described in detail with examples which do not limit the present invention.

### <Example 1>

A manufacturing method of a conductive sheet according to the present invention will now be described.

As an insulating substrate, a long-sized polyimide film (trade name: Apical, manufactured by Kaneka Corporation) cut to have thickness of 50 µm, a width of 250 mm and length of 100 m was wound around a core and then set to a feeding-out shaft of a sputtering apparatus, while an end thereof was set to a reeling-up shaft.

A degree of vacuum in a chamber of the sputtering apparatus was set to 1 x 10⁻³ Pa with a vacuum pump. Since the ion beam gun is also provided in the sputtering apparatus, the insulating substrate was first irradiated with cations by the ion beam gun, and then the metal layer was formed.

Processing with the ion beam gun was performed with argon cations in conditions of 100 cc/minute of argon gas as a raw material for cations, 0.5 kW/dm² of an electrode current, and an irradiation time of 4 seconds with a degree of vacuum of 0.5 x 10⁻¹ Pa (after injection of the gas). The surface roughness value Ra of a portion of the insulating substrate irradiated with cations as described above, which was measured using a probe of an atomic force microscope (a scanning probe microscope SPM-9500J3 manufactured by Shimadzu Corporation) and by setting a measurement range to 2 µm × 2 µm in a contact mode thereof, was 40 nm.

In a sputtering step following the aforementioned processing, the metal layer was formed on a whole surface of the insulating substrate irradiated with cations in conditions as follows.

To five targets of the sputtering apparatus, an alloy ofNi:Cr = 80:20 as a target No. 1 and Cu as target Nos. 2-5 were respectively attached. In conditions of 100 cc/minute of argon gas injection, 0.5 kW/dm² of a target current, and a degree of vacuum of 0.5 × 10⁻¹ Pa (after injection of the gas) for the target No. 1 having the Ni:Cr alloy attached thereto, and conditions of 200 cc/minute of argon gas injection, 1 kW/dm² of a target current, and a degree of vacuum of 0.5 × 10⁻¹ Pa (after injection of the gas) for each of the target Nos. 2-5 having Cu attached thereto, a metal layer (referred to as a first metal layer for convenience sake) formed with the Ni:Cr alloy was formed on one surface of the insulating substrate, and a metal layer (referred to as a second metal layer for convenience sake) formed with Cu was formed on the first metal layer by sputtering of the metals. Thereafter, the vacuum state of the sputtering apparatus was removed.

Samples were taken at points of 10 m, 50 m and 90 m from one end of the insulating substrate, and cross sections thereof were cut using an FIB (Focused Ion Beam) apparatus to measure thicknesses thereof. For every point, thickness of the first metal layer (that is, the metal layer formed with the Ni:Cr alloy) was 70 Å and thickness of the second metal layer (that is, the metal layer formed with Cu) was 2500 A.

Thereafter, the insulating substrate having a plurality of metal layers (two layers) formed and stacked on one surface thereof as described above was set on a continuous plating apparatus, and the conductive layer was formed on the metal layer (the second metal layer) by the electroplating method in conditions as described below. First, acid activation processing for the metal layer was performed by continuously immersing the insulating substrate in an acid activation bath filled with 7 % sulfuric acid at a temperature of 30 °C for 60 seconds.

After washing with pure water for 3 times, a plating bath of the apparatus was filled with a plating solution (consisting of 110 g/l of copper sulfate, 160 g/l of sulfuric acid, 60 ppm of chlorine, and 20 cc/l of Top Lucina 380 H (produced by Okuno Chemical Industries Co., Ltd.)), and the insulating substrate was continuously immersed with a moving speed of 1.0 m/minute and was subjected to electroplating at a solution temperature of 30 °C with a current density of 4 A/dm² for 11 minutes to form the conductive layer formed with Cu on the metal layer (the second metal layer).

The insulating substrate having the conductive layer formed as described above was washed with pure water for 5 times. Then, drip-drying was performed with dry air of 105 °C passed through a high efficiency filter (a size of an aperture of the filter is at most 0.5 µm) for sufficient drying to obtain the conductive sheet of the present invention.

Samples were taken at points of 10 m, 50 m and 90 m from one end of the conductive sheet obtained as above, and cross sections thereof were cut using the FIB apparatus to measure thickness of the conductive layer. For every point, an average of the thickness was 10.4 µm.

When an unprescribed circuit was formed with the metal layer and the conductive layer in the conductive sheet obtained as above, a very fine circuit could be obtained.

### <Example 2>

A conductive sheet was obtained similarly as in example 1 except that an irradiation time with cations was set to 0.02 seconds. The surface roughness value Ra of the insulating substrate of the obtained conductive sheet, which was measured in the same conditions as in example 1, was 0.2 nm.

When an unprescribed circuit was formed with the metal layer and the conductive layer in the conductive sheet obtained as above, a very fine circuit could be obtained.

### <Example 3>

A conductive sheet was obtained similarly as in example 1 except that an irradiation time with cations was set to 8 seconds. The surface roughness value Ra of the insulating substrate of the obtained conductive sheet, which was measured in the same conditions as in example 1, was 80 nm.

When an unprescribed circuit was formed with the metal layer and the conductive layer in the conductive sheet obtained as above, a very fine circuit could be obtained.

### <Example 4>

A conductive sheet was obtained similarly as in example 1 except that an irradiation time with cations was set to 20 seconds. The surface roughness value Ra of the insulating substrate of the obtained conductive sheet, which was measured in the same conditions as in example 1, was 200 nm.

When an unprescribed circuit was formed with the metal layer and the conductive layer in the conductive sheet obtained as above, a very fine circuit could be obtained.

### <Comparative Example 1>

A conductive sheet was obtained similarly as in example 1 except that an irradiation time with cations was set to 25 seconds. The surface roughness value Ra of the insulating substrate of the obtained conductive sheet, which was measured in the same conditions as in example 1, was 250 nm.

When a circuit was formed with the metal layer and the conductive layer in the conductive sheet obtained as above, a fine circuit as in the conductive sheet of each of the examples described above could not be obtained.

### <Comparative Example 2>

A conductive sheet was obtained similarly as in example 1 except that bombardment processing using a bombardment apparatus in place of the irradiation with cations using the ion beam gun was performed. The bombardment processing was performed at a temperature of 110 °C set by a heater with 120 cc/minute of Ar gas and an output of 0.9 kW.

The surface roughness value Ra of the insulating substrate of the obtained conductive sheet, which was measured in the same conditions as in example 1, was 0.1 nm.

### <Comparative Example 3>

A conductive sheet was obtained similarly as in example 1 except that chemical processing using potassium permanganate as a chemical in place of the irradiation with cations using the ion beam gun was performed based on a normal method.

The surface roughness value Ra of the insulating substrate of the obtained conductive sheet, which was measured in the same conditions as in example 1, was 40 nm.

### <Adhesion Test>

Adhesion strength between the insulating substrate and the conductive layer in the conductive sheet of each of examples 1-4 and comparative examples 2-3 was measured using a peel test apparatus (MODEL 1305N, manufactured by Aikoh Engineering Co., Ltd.). More specifically, the conductive sheet obtained in each of the examples and comparative examples was cut to a width of 1 cm, a side of the insulating substrate thereof was fixed with a double-faced tape, while an end of the conductive layer was peeled off for 20 mm to attach a hook of the test apparatus to that portion, and then the conductive layer was peeled off (peeling conditions: a peeling speed of 50 mm/minute and a peeling angle of 90°) to measure the adhesion strength between the insulating substrate and the conductive layer.

The results are shown in Table 1 below. Each value shown is an average of three measurements.

**Table 1**

| | Adhesion Strength |
|---|---|
| Example 1 | 1.49 kg/cm |
| Example 2 | 1.08 kg/cm |
| Example 3 | 1.53 kg/cm |
| Example 4 | 1.69 kg/cm |
| Comparative Example 2 | 0.74 kg/cm |
| Comparative Example 3 | 0.21 kg/cm |

As is obvious from Table 1, when each example is compared with each comparative example, it is recognized that the adhesion strength is increased by the irradiation with cations by the ion beam gun. In particular, by comparison of each example with comparative example 2, it is recognized that the adhesion strength is substantially increased by setting the surface roughness value Ra to at least 0.2 nm. On the other hand, by comparison of each example with comparative example 3, it is recognized that the adhesion strength is substantially increased by the irradiation with cations even when the surface roughness value Ra is similar.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A conductive sheet (1) having a metal layer (3) formed on at least a portion of a surface of an insulating substrate (2); wherein
said insulating substrate (2) has a long size of 1-10000 m in length, at least a portion of the surface thereof is irradiated with cations to set a surface roughness value Ra of an irradiated portion to 0.2-200 nm, and said metal layer (3) is formed on the portion irradiated with cations by a sputtering method or a deposition method.

2. The conductive sheet (1) according to claim 1, wherein
a conductive layer (4) is formed on at least a portion of a surface of said metal layer (3) by an electroplating method or an electroless plating method.

3. The conductive sheet (1) according to claim 2, wherein
said metal layer (3) and said conductive layer (4) form a circuit.

4. The conductive sheet (1) according to claim 2, wherein
circuits of a plurality of units are formed with said metal layer (3) and said conductive layer (4) on said insulating substrate (2), and said insulating substrate (2) is cut to divide said circuits of a plurality of units, unit by unit.

5. A product using the conductive sheet (1) according to claim 4.

6. The product according to claim 5, wherein
said product is any of a semiconductor product, an electrical product, an electronic product, a circuit board, an antenna circuit board, a package, an electromagnetic wave shielding material, an automobile, a solar cell, and an IC card.

7. A manufacturing method of a conductive sheet (1) having a metal layer (3) formed on at least a portion of a surface of an insulating substrate (2), comprising the steps of:
using said insulating substrate (2) having a long size of 1-10000 m in length and continuously irradiating at least a portion of the surface thereof with cations to set a surface roughness value Ra of an irradiated portion to 0.2-200 nm; and
forming said metal layer (3) on said portion irradiated with cations by a sputtering method or a deposition method.

8. The manufacturing method of a conductive sheet (1) according to claim 7, wherein
said step of irradiating with cations and said step of forming said metal layer (3) are successively performed within one apparatus.

9. The manufacturing method of a conductive sheet (1) according to claim 7, further comprising the step of
forming a conductive layer (4) on at least a portion of a surface of said metal layer (3) by an electroplating method or an electroless plating method.

10. The manufacturing method of a conductive sheet (1) according to claim 9, further comprising the step of
forming a circuit for said metal layer (3) and said conductive layer (4).

11. The manufacturing method of a conductive sheet (1) according to claim 9, further comprising the steps of:
forming circuits of a plurality of units with said metal layer (3) and said conductive layer (4) on said insulating substrate (2); and
cutting said insulating substrate (2) to divide said circuits of a plurality of units, unit by unit.
